## Europäisches Patentamt
## European Patent Office
## Office européen des brevets

(19)

(11) Publication number: **0 110 060**
**B1**

(12)

# EUROPEAN PATENT SPECIFICATION

(45) Date of publication of patent specification: **07.01.87**

(21) Application number: **83109944.5**

(22) Date of filing: **05.10.83**

(51) Int. Cl.⁴: **H 03 K 19/096**, H 03 K 5/02, H 03 K 3/356, G 11 C 8/00

(54) FET voltage level shift circuitry.

(30) Priority: **01.11.82 US 437991**

(43) Date of publication of application:
**13.06.84 Bulletin 84/24**

(45) Publication of the grant of the patent:
**07.01.87 Bulletin 87/02**

(84) Designated Contracting States:
**DE FR GB**

(56) References cited:
EP-A-0 036 743
EP-A-0 076 733
WO-A-82/03513
GB-A-2 087 151
US-A-3 588 537
US-A-3 879 621
US-A-4 038 567
US-A-4 096 402
US-A-4 110 639
US-A-4 284 910

IEEE JOURNAL OF SOLID-STATE CIRCUITS,
vol. SC-17, no. 5, October 1982 BENEVIT et al.
"256K dynamic RAM", page 859

(73) Proprietor: **International Business Machines
Corporation
Old Orchard Road
Armonk, N.Y. 10504 (US)**

(72) Inventor: **Chao, Hu Herbert
3081 Radcliffe Drive
Yorktown Heights New York 10598 (US)**

(74) Representative: **Lewis, Alan John
IBM United Kingdom Limited Intellectual
Property Department Hursley Park
Winchester Hampshire SO21 2JN (GB)**

(56) References cited:
**IEEE JOURNAL OF SOLID-STATE CIRCUITS,
vol. SC-16, no. 5, October 1981, New York T.
WADA et al. "A 16 DIP, 64 kbit, static MOS-
RAM", pages 488-491**

**U. TIETZE / CH. SCHENK :"Halbleiter-
Schaltungstechnik", 5th edition, Springer
Verlag Berlin Heidelberg New York, 1980,
pages 156 - 159**

Courier Press, Leamington Spa, England.

## Description

The invention relates to FET voltage level shift circuitry and is more particularly, but not exclusively concerned with circuits for converting TTL logic signal levels to MOS logic signal levels.

In the MOS semiconductor art large scale integrated circuits are produced. Included among this class of semiconductor devices are MOS memories which are addressed through a plurality of address signals and the logical complement of these signals.

In many applications of memories and other types of circuit devices produced in the technology it is necessary to drive the circuit device from another type of semiconductor logic circuitry such as TTL. The TTL circuitry operates at different voltage levels providing a binary 1 at greater than 2.2 volts and a binary 0 at less than 0.6 volts. These logic levels are insufficient and in some instances incompatible with MOS logic levels.

Buffer circuits have been devised to provide conversion of TTL logic levels to levels compatible with MOS logic circuits. These are included in a 16K dynamic RAM, No. MK 4116, manufactured by MOSTEK which can be driven directly with TTL logic. The device is power efficient but requires three clocks to operate. The multiple clocks impose an undesirable speed limitation on the operation of the buffer and hence to the remaining circuitry connected with the buffer.

In an other type of RAM which interfaces with TTL logic circuits, manufactured by Hitachi as HM6147, a high speed static 16K RAM, the speed of the device is adequate. The power efficiency, however, suffers because of the d.c. current flow through an inverter in the device which receives the TTL driving signals.

US—A—4,038,567 discloses an input signal buffer circuit capable of translating an input signal at one voltage level to an output signal at a different voltage level. The buffer circuit comprises a cross-coupled bistable input circuit having two inputs to which the input signal and a reference signal are gated by a first timing signal and two output nodes at which corresponding complementary output voltages are manifested in response to a second timing signal. The circuit further comprises two circuit-paths, gated by a third timing signal, respectively connecting the two output nodes to two output circuits providing two complementary output signals in response to a fourth timing signal applied thereto. In addition a fifth, reset timing signal is used to reset the input and output circuits. The generation and use of five timing signal impose limitations on the speed and efficiency of the foregoing circuit which the Applicants seek to avoid.

US—A—3,879,621 discloses a sense amplifier for an FET memory array comprising a cross-coupled bistable circuit having two input nodes to which the complementary outputs of a selected memory cell are respectively gated via first and second FET's in response to a first timing signal to set the bistable circuit. Thereafter an output is taken from the amplifier by gating a third FET connected in series with the bistable circuit, to pass a current therethrough. In one embodiment the first and second FETs are of one type and the third FET is of the other type so that a single bi-level timing signal can be operative at one level to gate the first and second FETs on the third FET off, and vice versa at its other level. In another embodiment the first, second and third FETs are of the same type and are gated by complementary timing signals.

U. Tietze and Ch. Schenk's publication "Halbleiter-Schaltungstechnik" 5th edition, Springer-Verlag Berlin Heidelberg New York 1980 at pages 156—159 discloses various FET circuits. One such circuit, called "a transmission gate" and shown in Fig. 9.31b of that publication, comprises two FETs connected in series to form an inverter circuit and two complementary FETs connected in parallel. The input and output of the inverter circuit are respectively connected to the gates of the complementary FETs so that for one input one of the complementary FETs conducts and for the other input, the other complementary FET conducts. The inverter circuit is further described and shown in Fig. 9.28.

It is an object of the invention to provide an interface circuit between any type of MOS logic circuit and an TTL logic circuit.

It is a more particular object of the invention to provide an address buffer for a MOS memory which is high speed and power efficient.

These and other objects accomplished by circuitry in accordance with the present invention. A cross- coupled latch is provided which is controlled by chip enable signals CSI, and its complement $\overline{CSI}$. During one state of the CSI and $\overline{CSI}$ signals, the latch is disabled conserving power, and the cross coupled latch receives as an input a reference level and a TTL logic level. The latch will assume a state corresponding to the received TTL level during a second state of the signals. A pass circuit connects the latch nodes to first and second inverter chains. During the second state of the CSI and $\overline{CSI}$ signals the latch assumes the appropriate logic state defined by the reference level and TTL level and the pass circuit makes the connection between inverter chains and the nodes providing a MOS logic level and its complement. During the one state of the CSI and $\overline{CSI}$ signals the cross-coupled latch is isolated from the inverter chains by an interrupt function of the pass circuit.

Accordingly the invention provides an input signal buffer circuit capable of translating an input signal at one voltage level to an output signal at a different voltage level, said circuit comprising a cross-coupled bistable input circuit having two input paths to which the input signal and a reference signal are gated and two output nodes (N1, N2) at which corresponding complementary output voltages are manifested, two output circuits capable of providing two complementary output signals at said different voltage level, and two gated signal-paths respectively connecting the two output nodes of the bistable circuit to the input nodes of the output circuits so that the setting of the bistable circuit controls the output signals, said buffer circuit being characterised by requiring only a single timing signal in true and complementary form (CSI and $\overline{CSI}$) and by comprising two gated voltage-clamping-paths respectively connecting the input nodes (N3, N4) of the output circuits to a reference voltage input terminal GDN) and means, responsive to a first state of the complementary timing signals, for gating the input and reference signals onto the input paths of the bistable circuit and the reference voltage (GDN) to the input nodes of the output circuits via the voltage-clamping-paths while preventing gating of the complementary outputs of the bistable circuit to the input nodes of the output circuits via the signal-paths and, responsive to the other state of the complementary timing signals, for gating the complementary outputs of the bistable circuit to the input nodes of the output circuits via the signal-paths while preventing gating of the input and reference signals to the input paths of the bistable circuit and of the reference voltage to the input nodes of the output circuits via the voltage-clamping-path.

The invention will now be further described with reference to the accompanying drawings, in which:—

Figure 1 is a block diagram of a circuit according to one embodiment of the invention which provides MOS logic levels from TTL logic levels.

Figure 2 is a schematic illustration of a circuit according to a preferred embodiment of the invention.

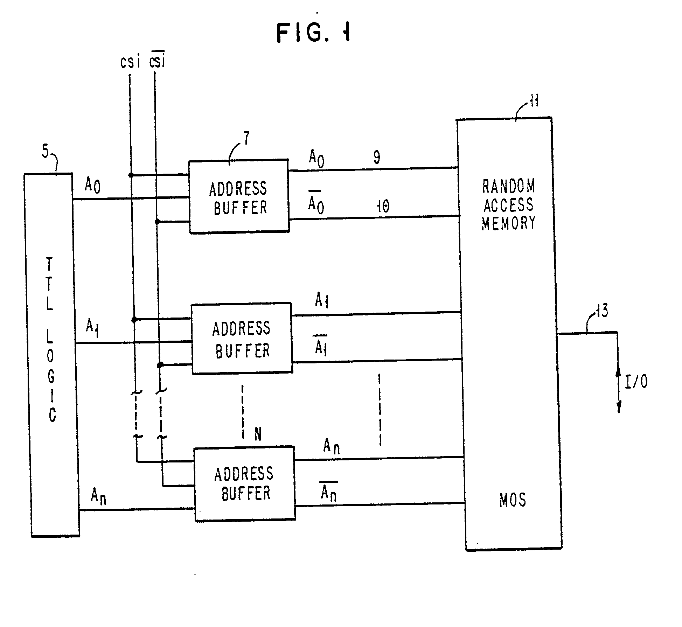

Referring now to Figure 1, there is shown an MOS RAM 11 having a plurality of address inputs Ao through An. Although the preferred embodiment is described in terms of an address buffer for a memory, its use for converting TTL logic levels to MOS logic levels is applicable to other circuit devices. The address lines also include complementary inputs $\overline{Ao}$ to $\overline{An}$. The MOS RAM 11 is addressed by a TTL logic circuit 5. The input TTL logic levels are less than .6 volts and greater than 2.2 volts corresponding to a binary 0 and 1 respectively. The output logic levels are between 0 and 5 volts respectively for driving the address inputs of MOS RAM 11. The buffer 7 requires a single clock represented by CSI and its complement $\overline{CSI}$.

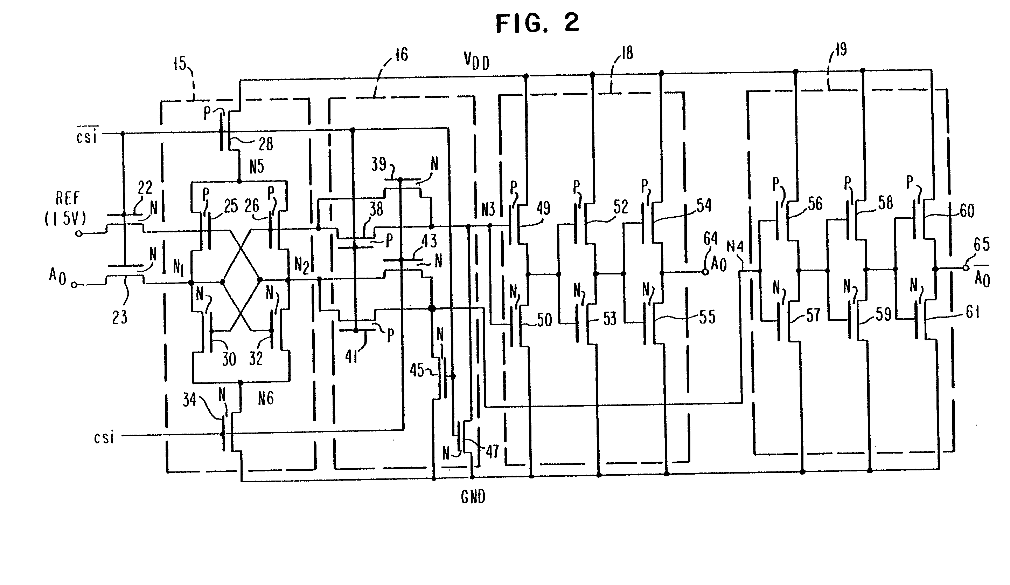

Referring now to Figure 2, one embodiment of the buffer is shown implemented in MOS semiconductor techniques. The elements of the buffer are field effect transistors of either N or P channel type hereinafter referred to as an NFET or PFET. The input cross coupled latch is provided by circuitry 15. The cross coupled latch 15 includes first and second switches comprising NFET 34 and PFET 28. The switches feed a pair of parallel connected, serial transistor pairs 25, 30 and 26, 32. FET 25 and 26 are P channel and 30 and 32 are N channel. The gates of each transistor pair 25, 30 and 26, 32 are connected together with the junction of an opposite transistor pair to form first and second Nodes $N_1$, $N_2$.

The cross coupled latch 15 receives on each node $N_1$, $N_2$ a reference voltage and TTL logic level through NFET 22 and NFET 23. The cross coupled latch 15 receives the node input voltages during $\overline{CSI}=1$. The chip select, CSI, occurs when the MOSRAM 11 address lines are to be addressed. The CSI pulse along with its complement $\overline{CSI}$ is the only clock pulse required to operate the buffer.

The nodes of the cross coupled latch 15 are connected to a current path circuit 16. The current path circuit 16 also operates under control of CSI and $\overline{CSI}$. During CSI=1, the nodes are connected via current path circuit 16 to the inputs $N_3$, $N_4$ of inverter chains 18 and 19. During the period when $\overline{CSI}=1$ and CSI=0 the connection between the inverter chains 18 and 19 and the nodes $N_1$, $N_2$ are interrupted thus isolating the inverter chains from the cross coupled latch 15. The current path operates in a PASS mode in response to the CSI pulse=1 and $\overline{CSI}$ pulse=0 by gating NFET 39 and 43 and PFET 38 and 41 into conduction and maintaining NFET 45 and 47 OFF. During CSI=1 NFET 39, 43 and PFET 38, 41 are gated off thus isolating the inverter chains 18 and 19 from Nodes $N_1$, $N_2$ of the cross coupled latch 15, and NFET 45 and 47 are gated on returning the inverter chains 18, 19 inputs, $N_3$, $N_4$ to ground.

The inverter chains are identical except for their input connections. The chains comprise three PFETS 49, 52, 54 and 56, 58, 60 having a drain connection to VDD, and serially connected to three NFETS, 50, 53, 55, and 57, 59, 61 which provide through respective source connections a return connection to ground. The gates of a pair of serially connected transistors are connected together to form an input connection, and the common connections of the NFET and PFET form an output connection.

The entire circuit functions to minimize power consumption and maximize speed using only a single clock pulse CSI and its complement. The nodes $N_1$, $N_2$ are established at the TTL level Ao and REF voltage, 1.5 volts, during $\overline{CSI}=1$. At the beginning of CSI=1, the switches in the latch 15 comprising NFET 34 and PFET 28 are activated and latch 15 assumes the state determined by TTL logic level $\overline{Ao}$. Inverter chains 18 and 19 are connected to the nodes $N_1$ and $N_2$ and provide complementary MOS output levels Ao and $\overline{Ao}$. At the end of $\overline{CSI}=1$, the cross coupled latch 15 is decoupled from the inverter chains 18 and 19. Inputs to the inverter chains 18 and 19 are maintained at GND by NFETS 45, 47 and the outputs are maintained at VDD. Maintaining the cross coupled latch 15 off prior to CSI=1, reduces over all power consumption.

The buffer of Figure 2 can be implemented in CMOS. The following description of each of the FETS of Figure 2 can be implemented to yield one embodiment of the invention.

| Transistor No. | Type | Width/Length (in Microns) |
|---|---|---|
| 22, 23 | N | 4 |
| 25, 26, 28 | P | 16 |
| 30, 32 | N | 6.4 |
| 34 | N | 8.0 |
| 38, 41 | P | 5.0 |
| 39, 43 | N | 2.0 |
| 45, 47 | N | 4.0 |
| 49, 56 | P | 10.0 |
| 50, 57 | N | 8.0 |
| 52, 58 | P | 30.0 |
| 53, 59 | N | 12.0 |
| 54, 60 | P | 125.0 |
| 55, 61 | N | 100.0 |

The foregoing circuit provides a low power high speed address buffer for converting TTL level signals to MOS level signals and their complement.

The invention has been described in terms of one embodiment but is not limited to the details of that embodiment.

**Claims**

1. An input signal buffer circuit capable of translating an input signal at one voltage level to an output signal at a different voltage level, said circuit comprising a cross-coupled bistable input circuit (15) having two input paths to which the input signal and a reference signal are gated and two output nodes (N1, N2) at which corresponding complementary output voltages are manifested, two output circuits (18, 19) capable of providing two complementary output signals at said different voltage level, and two gated signal-paths (16) respectively connecting the two output nodes of the bistable circuit to the input nodes of the output circuits so that the setting of the bistable circuit controls the output signals, said buffer circuit being characterized by requiring only a single timing signal in true and complementary form (CSI and $\overline{CSI}$) and by comprising two gated voltage-clamping-paths (45, 47) respectively connecting the input nodes (N3, N4) of the output circuits to a reference voltage input terminal (GDN) and means, responsive to a first state of the complementary timing signals, for gating the input and reference signals onto the input paths of the bistable circuit and the reference voltage (GDN) to the input nodes of the output circuits via the voltage-clamping-paths while preventing gating of the complementary outputs of the bistable circuit to the input nodes of the output circuits via the signal-paths and, responsive to the other state of the complementary timing signals, for gating the complementary outputs of the bistable circuit to the input nodes of the output circuits via the signal-paths while preventing gating of the input and reference signals to the input paths of the bistable circuit and of the reference voltage to the input nodes of the output circuits via the voltage-clamping-path.

2. A buffer circuit as claimed in claim 1, further characterised in that the gating/preventing means comprise the controlled current paths of eight FET's (22, 23, 38, 39, 41, 43, 45, 47) respectively connected in the input paths to the bistable circuit, the signal-paths to the output circuits and the voltage-clamping-paths.

3. A buffer circuit as claimed in claim 2, further characterised in that two FET's (39, 43) in the signal-path are of a first conductivity type and are connected to be controlled by the true form of the timing signal (CSI) and another two FET's (38, 41) in the signal-paths are of the opposite conductivity type and are connected to receive the complementary form of the timing signal ($\overline{CSI}$) and in that the two FET's (45, 47) in the voltage-clamping-paths are of the first conductivity type and are connected to receive the complementary form of the timing signal ($\overline{CSI}$).

4. A buffer circuit as claimed in claim 1, 2 or 3, further characterised in that the bistable circuit (15) comprises a first pair and a second pair of transistors (25, 30: 26, 32), each of said transistor pairs including an NFET and a PFET serially connected; the gate connections of each transistor pair forming first and second nodes (N1, N2) with the common connection of the remaining transistor pair, and first and second switches (28, 34) for supplying current to first and second ends of said transistor pairs in response to timing signals (CSI and $\overline{CSI}$) applied thereto.

5. A buffer circuit as claimed in claim 1, 2, 3 or 4, further characterised in that the output circuits comprise first and second FET inverter chains connected to provide complementary logic signals at the different voltage level in response to complementary input signals.

6. A buffer circuit as claimed in Claim 1, 2, 3, 4 or 5 characterised in that the buffer circuit is a FET circuit, that the input signal is represented by the potential difference between a reference voltage and a first logic voltage at one or other of two first voltage levels and the output signal is represented by the potential difference between a second reference voltage and a second logic voltage at one or other of two second voltage levels, that the said two output circuits (18, 19) each comprising at least one voltage transition stage including two complementary FET's (54, 55: 60, 61) having their controlled current paths in series and their gates connected to control terminals (N3, N4), said circuits being connected in parallel between supply lines (VDD, GND) to which the second voltage levels are applied to two circuit-paths respectively connecting the two output nodes ($N_1$, $N_2$) to gate control terminals ($N_3$, $N_4$), the said circuit-paths including the controlled current paths of at least two isolating transistors (38, 39, 41, 43) of which the gates are respectively connected to terminals to which complementary values, binary input timing signals (CSI and $\overline{\text{CSI}}$) are supplied in use to render the isolating transistor conductive for timed intervals, the said two voltage-clamping-paths respectively connecting the control terminals ($N_3$, $N_4$) to one of the supply lines, said voltage-clamping-paths respectively including the controlled current paths of two clamping transistors (45, 47) of which the gates are respectively connected to at least one of the aforesaid terminals to which the timing signal is supplied, said isolating transistors and said clamping transistors being of such conductivity type that during the timed intervals in which the isolating transistors conduct, the clamping transistors are rendered non-conducting and during the intervening intervals in which the isolating transistors are non-conducting, the clamping transistors are rendered conducting.

**Patentansprüche**

1. Eingangssignal-Pufferschaltung, welche in der Lage ist, ein Eingangssignal auf einem Spannungspegel auf ein Ausgangssignal auf einem anderen Spannungspegel zu übersetzen, wobei die Schaltung eine kreuzgekoppelte bistabile Eingangsschaltung (15) mit zwei Eingangswegen, auf welche das Eingangssignal und ein Referenzsignal getort - werden, und zwei Ausgangsknoten (N1, N2), an welchen entsprechende komplementäre Ausgangsspannungen erscheinen, zwei Ausgangsschaltungen (18, 19), welche in der Lage sind, zwei komplementäre Ausgangssignale auf dem anderen Spannungspegel zu liefern, und zwei getorte Signalwege (16), welche entsprechend die zwei Ausgangsknoten der bistabilen Schaltung mit den Eingangsknoten der Ausgangsschaltungen verbinden, so daß die Einstellung der bistabilen Schaltung die Ausgangssignale steuert, aufweist, wobei die Pufferschaltung dadurch gekennzeichnet ist, daß sie nur ein einziges Taktsignal in wahrer und komplementärer Form (CSI und $\overline{\text{CSI}}$) erfordert und zwei getorte Spannungsklemmwege (45, 47), welche entsprechend die Eingangsknoten (N3, N4) der Ausgangsschaltungen mit einem Referenzspannungseingang (GDN) verbindet, und Mittel, ansprechend auf einen ersten Zustand der komplementären Taktsignale, zur Torung des Eingangs- und des Referenzsignals auf die Eingangswege der bistabilen Schaltung und der Referenzspannung (GDN) auf die Eingangsknoten der Ausgangsschaltungen über die Spannungsklemmwege, und andererseits zur Verhinderung einer Torung der komplementären Ausgänge der bistabilen Schaltung auf die Eingangsknoten der Ausgangsschaltungen über die Signalwege, und, ansprechend auf den anderen Zustand der komplementären Taktsignale, zur Torung der komplementären Ausgänge der bistabilen Schaltung auf die Eingangsknoten der Ausgangsschaltungen über die Signalwege, und andererseits zur Verhinderung einer Torung des Eingangs- und des Referenzsignals auf die Eingangswege der bistabilen Schaltung und der Referenzspannung auf die Eingangsknoten der Ausgangsschaltungen über den Spannungsklemmweg umfaßt.

2. Pufferschaltung nach Anspruch 1, ferner dadurch gekennzeichnet, daß die Torrungs/Verhinderungsmittel die gesteuerten Stromwege von acht FETs (22, 23, 38, 39, 41, 43, 45, 47) umfassen, die entsprechend in die Eingangswege zur bistabilen Schaltung, die Signalwege zu den Ausgangsschaltungen und die Spannungsklemmwege geschaltet sind.

3. Pufferschaltung nach Anspruch 2, ferner dadurch gekennzeichnet, daß die zwei FETs (39, 43) in den Signalwegen von einem ersten Leitungstyp und so angeschlossen sind, daß sie durch die wahre Form des Taktsignals (CSI) gesteuert werden, und daß zwei weitere FETs (38, 41) in den Signalwegen vom entgegengesetzten Leitungstyp und so angeschlossen sind, daß sie die komplementäre Form des Taktsignals ($\overline{\text{CSI}}$) erhalten, und daß die zwei FETs (45, 47) in den Spannungsklemmwegen vom ersten Leitungstyp und so angeschlossen sind, daß sie die komplementäre Form des Taktsignals ($\overline{\text{CSI}}$) erhalten.

4. Pufferschaltung nach Anspruch 1, 2 oder 3, ferner dadurch gekennzeichnet, daß die bistabile Schaltung (15) ein erstes Paar und eine zweites Paar von Transistoren (25, 30: 26, 32)1 wobei jedes der Transistorpaare in Reihenschaltung einen NFET und einen PFET enthält, wobei die Gate-Anschlüsse eines jeden Transistorpaares einen ersten und zweiten Knoten (N1, N2) mit dem gemeinsamen Anschluß des verbleibenden Transistorpaares bilden, und einen ersten und zweiten Schalter (28, 34) zur Zuführung von Strom an das erste und das zweite Ende des Transistorpaares ansprechend auf die Aufgabe von Taktsignalen (CSI und $\overline{\text{CSI}}$) auf diese umfaßt.

5. Pufferschaltung nach Anspruch 1, 2, 3 oder 4, ferner dadurch gekennzeichnet, daß die Ausgangsschaltungen eine erste und zweite FET-Inverterkette umfaßt, welche so angeschlossen sind, daß sie komplementäre Logiksignale auf den verschiedenen Spannungspegeln ansprechend auf komplementäre Eingangssignale liefern.

6. Pufferschaltung nach Anspruch 1, 2, 3, 4 oder 5, dadurch gekennzeichnet, daß die Pufferschaltung eine FET-Schaltung ist, daß das Eingangssignal durch die Potentialdifferenz zwischen einer Referenzspannung und einer ersten Logikspannung auf dem einen oder anderen von zwei ersten Spannungspegeln dargestellt wird und das Ausgangssignal durch die Potentialdifferenz zwischen einer zweiten Referenzspannung und einer zweiten Logikspannung auf dem einen oder anderen von zwei zweiten Spannungspegeln dargestellt wird, daß die zwei Ausgangsschaltungen (18, 19) jeweils wenigstens eine Spannungsübergangsstufe mit zwei komplementären FETs (54, 55: 60, 61), deren gesteuerte Stromwege in Reihe liegen und deren Gates mit Steueranschlussen ($N_3$, $N_4$) verbunden sind, aufweisen, wobei die Schaltungen parallel zwischen Versorgungsleitungen (VDD, GND), auf welche die zweiten Spannungspegel gegeben werden, angeschlossen sind, wobei die zwei Schaltungswege entsprechend die zwei Ausgangsknoten ($N_1$, $N_2$) mit Gate-Steueranschlüssen ($N_3$, $N_4$) verbinden, wobei die Schaltungswege die gesteuerten Stromwege von wenigstens zwei Trenntransistoren (38, 39, 41, 43) enthalten, deren Gates entsprechend mit Anschlüssen verbunden sind, auf welche komplementäre Werte, binäre Eingangstaktsignale (CSI und $\overline{CSI}$) im Betrieb gegeben werden, um die Trenntransistoren für zeitlich festgelegte Intervalle leitend zu machen, wobei die zwei Spannungsklemmwege entsprechend die Steueranschlüsse ($N_3$, $N_4$) mit einer der Versorgungsleitungen verbinden, wobei die Spannungsklemmwege entsprechend die gesteuerten Stromwege von zwei Klemmtransistoren (45, 47) enthalten, deren Gates entsprechend mit wenigstens einem der vorgenannten Anschlüsse, auf welche die Taktsignale gegeben werden, verbunden sind, wobei die Trenntransistoren und die Klemmtransistoren von solchem Leitungstyp sind, daß während der zeitlich festgelegten Intervalle, in welchen die Trenntransistoren leiten, die Klemmtransistoren nicht-leitend gemacht werden, und während der dazwischenliegenden Intervalle, in welchen die Trenntransistoren nichtleitend sind, die Klemmtransistoren leitend gemacht werden.

## Revendications

1. Un circuit d'interface de signal d'entrée capable de transformer un signal d'entrée à un premier niveau de tension en un signal de sortie à un niveau de tension différent, ce circuit comprenant un circuit d'entrée bistable à couplage croisé (15) ayant deux voies d'entrée auxquelles le signal d'entrée et un signal de référence sont appliqués sélectivement et deux noeuds de sortie (N1, N2) sur lesquels apparaissent des tensions de sortie complémentaires correspondantes, deux circuits de sortie (18, 19) capables de fournir deux signaux de sortie complémentaires au niveau de tension différent, et deux voies de signal commandées (16) qui connectent respectivement les deux noeuds de sortie du circuit bistable aux noeuds d'entrée des circuits de sortie, de façon que l'état du circuit bistable commande les signaux de sortie, ce circuit d'interface étant caractérisé par le fait qu'il ne nécessite qu'un seul signal d'horloge sous forme directe et complémentaire (CSI et $\overline{CSI}$), et par le fait qu'il comprend deux voies de fixation de tension commandées (45, 47) qui connectent respectivement les noeuds d'entrée (N3, N4) des circuits de sortie à une borne d'entrée de tension de référence (GND) et des moyens qui réagissent à un premier état des signaux d'horloge complémentaires en transmettant les signaux d'entrée et de référence sur les voies d'entrée du circuit bistable et la tension de référence (GND) vers les noeuds d'entrée des circuits de sortie, par l'intermédiaire des voies de fixation de tension, tout en empêchant la transmission des signaux de sortie complémentaires du circuit bistable vers le noeuds d'entrée des circuits de sortie par l'intermédiaire des voies de signal, et qui réagissent à l'autre état des signaux d'horloge complémentaires en transmettant les signaux de sortie complémentaires du circuit bistable aux noeuds d'entrée des circuits de sortie, par l'intermédiaire des voies de signal, tout en empêchant la transmission des signaux d'entrée et de référence aux voies d'entrée du circuit bistable et de la tension de référence aux noeuds d'entrée des circuits de sortie, par l'intermédiaire de la voie de fixation de tension.

2. Un circuit d'interface selon la revendication 1, caractérisé en outre en ce que les moyens de transmission comprennent les voies de courant commandées du huit TEC (22, 23, 38, 39, 41, 43, 45, 47) connectées respectivement dans les voies d'entrée du circuit bistable, les voies de signal allant vers les circuits de sortie, et les voies de fixation de tension.

3. Un circuit d'interface selon la revendication 2, caractérisé en outre en ce que les deux TEC (39, 43) dans les voies de signal ont un premier type de conductivité et sont connectés de façon à être commandés par la forme directe du signal d'horloge (CSI), et deux autres TEC (38, 41) dans les voies de signal ont le type de conductivité opposé et sont connectés de façon à recevoir la forme complémentaire du signal d'horloge ($\overline{CSI}$) et en ce que les deux TEC (45, 47) se trouvant dans les voies de fixation de tension sont du premier type de conductivité et sont connectés de façon à recevoir la forme complémentaire du signal d'horloge ($\overline{CSI}$).

4. Un circuit d'interface selon la revendication 1, 2 ou 3, caractérisé en outre en ce que le circuit bistable (15) comprend une première paire et une seconde paire de transistors (25, 30; 26, 32), chacune de ces paires de transistors comprenant un TECN et un TECP connectés en série, les connexions de grille de chaque paire de transistors formant des premier et second noeuds (N1, N2) avec la connexion commune de la paire de transistors restante, et des premier et second éléments de commutation (28, 34) destinés à fournir du courant à des premières et secondes extrémités des paires de transistors, sous la dépendance de signaux d'horloge (CSI et $\overline{CSI}$) qui leur sont appliqués.

5. Un circuit d'interface selon la revendication 1, 2, 3 ou 4, caractérisé en outre en ce que les circuits de sortie comprennent des première et seconde chaînes d'inverseurs à TEC connectées de façon à fournir des signaux logiques complémentaires au niveau de tension différent, en réponse à des signaux d'entrée complémentaires.

6. Un circuit d'interface selon la revendication 1, 2, 3, 4 ou 5, caractérisé en ce que ce circuit d'interface est un circuit à TEC, en ce que le signal d'entrée est représenté par la différence de potentiel entre une tension de référence et une première tension logique à l'un ou l'autre de deux premiers niveaux de tension, et le signal de sortie est représenté par la différence de potentiel entre une seconde tension de référence et une seconde tension logique à l'un ou l'autre de deux seconds niveaux de tension, en ce que chacun des deux circuits de sortie (18, 19) comprend au moins un étage de transition de tension comprenant deux TEC complémentaires (54, 55; 60, 61) dont les voies de courant commandées sont connectées en série et dont les grilles sont connectées à des bornes de commande (N₃, N₄), ces circuits étant connectés en parallèle entre des lignes d'alimentation (VDD, GND) auxquelles les seconds niveaux de tension sont appliqués, les deux voies de circuit connectant respectivement les deux noeuds de sortie (N₁, N₂) à des bornes de commande de grille (N₃, N₄), les voies de circuit comprenant les voies de courant commandées d'au moins deux transistors d'isolation (38, 39, 41, 43) dont les grilles sont respectivement connectées à des bornes auxquelles des signaux d'horloge d'entrée binaires ayant des valeurs complémentaires (CSI et $\overline{CSI}$) sont appliqués pendant l'utilisation, pour provoquer la conduction du transistor d'isolation pendant des intervalles déterminés, les deux voies de fixation de tension connectant respectivement les bornes de commande (N₃, N₄) à l'une des lignes d'alimentation, ces voies de fixation de tension comprenant respectivement les voies de courant commandées de deux transistors de fixation de tension (45, 47) dont les grilles sont respectivement connectées à l'une au moins des bornes précitées auxquelles le signal d'horloge est appliqué, les transistors d'isolation et les transistors de fixation de tension ayant un type de conductivité tel que, pendant les intervalles déterminés au cours desquels les transistors d'isolation conduisent, les transistors de fixation de tension sont bloqués, et pendant les intervalles intermédiaires au cours desquels les transistors d'isolation sont bloqués, les transistors de fixation de tension sont placés à l'état conducteur.

# FIG. 1

FIG. 2